# DEMANDE DE BREVET EUROPEEN

(11) **EP 4 633 324 A1**
(43) Date de publication de la demande: **15.10.2025**
(21) Numéro de dépôt: 25169580.5
(22) Date de dépôt: 09.04.2025
(51) Int. Cl.: H10D 48/01, H10D 48/00, H10D 64/27, B82Y 10/00

(54) **DISPOSITIF À MATRICE DE BOITES QUANTIQUES COMPRENANT DES RÉGIONS DE COUPLAGE, AVEC GRILLES SUR CÔTÉS OPPOSÉS DU MATRICE DE BOITES QUANTIQUES**

(30) Priorité: 10.04.2024 FR 2403716
(71) Demandeur: Commissariat à l'Energie Atomique et aux Energies Alternatives, 75015 Paris (FR)
(72) Inventeur: BERTRAND, Benoit, 38054 GRENOBLE CEDEX 09 (FR); SADIK, Amina, 38054 GRENOBLE CEDEX 09 (FR)
(74) Mandataire: Cabinet Beaumont

(57) **Abrégé**

La présente description concerne un dispositif électronique (100) comprenant :
- une couche semi-conductrice (102) comprenant une matrice de boîtes quantiques (104) et des régions de couplage (106) chacune disposée entre deux boîtes quantiques adjacentes ;
- plusieurs premières grilles de commande (114), disposées les unes à côté des autres du côté d'une première face (116) de la couche semi-conductrice ;
- plusieurs deuxièmes grilles de commande (122), disposées les unes à côté des autres du côté d'une deuxième face (124) de la couche semi-conductrice ;
dans lequel les premières grilles de commande s'étendent selon leur plus grande dimension parallèlement à un premier axe et les deuxièmes grilles de commande s'étendent selon leur plus grande dimension parallèlement à un deuxième axe, et dans lequel des projections des premier et deuxième axes dans un même plan sont sécantes. Chacune des boîtes quantiques (104) est disposée en regard d'une des premières grilles de commande (114) et d'une des deuxièmes grilles de commande (122), et chacune des régions de couplage (106) est disposée en regard d'une des premières grilles de commande (114) et d'une des deuxièmes grilles de commande (122).

## Description

### Domaine technique

La présente description concerne de façon générale le domaine des dispositifs électroniques quantiques et de l'informatique quantique.

### Technique antérieure

Il existe des dispositifs électroniques quantiques comportant des qubits basés sur la formation de boîtes quantiques assurant le confinement de charges élémentaires (électrons ou trous) dans un semi-conducteur. Dans ces dispositifs, l'information quantique est, par exemple, codée sur le spin de ces charges. Le confinement des charges élémentaires dans les boîtes quantiques est réalisé selon les trois dimensions spatiales de ces boîtes (longueur, largeur et hauteur). Ce confinement peut être assuré de manière structurelle, par exemple en utilisant une alternance de matériaux selon au moins une dimension de l'espace, et/ou de manière électrostatique, par exemple par l'application d'un potentiel électrique sur une portion de matériau conducteur.

Les qubits peuvent être agencés dans une couche semi-conductrice sous la forme d'une matrice, c'est-à-dire en formant un réseau bidimensionnel de qubits dans un plan principal de la couche semi-conductrice. Par rapport à un agencement unidimensionnel, un tel agencement matriciel permet une meilleure interconnectivité entre les boîtes quantiques les plus proches voisines, et autorise donc une exécution plus efficace des algorithmes de correction d'erreur quantique, comme décrit dans le document de A.G. Fowler et al., « Surface codes: Towards practical large-scale quantum computation », Phys. Rev. A 86, 032324 (2012).

Plusieurs solutions ont été proposées pour superposer deux ou trois niveaux de grilles par l'intermédiaire desquels des potentiels de confinement électriques, ou potentiels chimiques, des boîtes quantiques sont créés dans un matériau semi-conducteur. De telles solutions sont décrites par exemple dans les documents FR 3 066 297 A1, US 10 593 756 B2 ou R. Li et al., « A crossbar network for silicon quantum dot qubits », Sci.Adv.4, 6 juillet 2018, Vol. 4, Issue 7 (2018). Ces grilles permettent d'ajuster localement le potentiel électrostatique des boîtes quantiques, c'est-à-dire la profondeur des puits de potentiel des boîtes quantiques, ainsi que le couplage tunnel, c'est-à-dire la hauteur des barrières tunnel ou des sites de blocage, entre les boîtes quantiques voisines. Ces solutions présentent toutes au moins une partie des inconvénients suivants :
- trop grand nombre de lithographies à mettre en œuvre pour réaliser les grilles ;
- étape(s) de gravure à mettre en œuvre en présence de topographies importantes ;
- écrantage électrostatique des niveaux de grille inférieurs, ce qui rend la structure très asymétrique ;
- besoin de déplacement des qubits pour réaliser des opérations entre eux ;
- grand nombre d'opérations requises par cycle de code de correction d'erreur.

### Résumé de l'invention

Il existe un besoin de proposer un dispositif électronique à matrice bidimensionnelle de boîtes quantiques ne présentant pas au moins une partie des inconvénients précédemment décrits.

Un mode de réalisation pallie tout ou partie de ces inconvénients et propose un dispositif électronique comprenant :
- une couche semi-conductrice comprenant une matrice de boîtes quantiques et des régions de couplage chacune disposée entre deux boîtes quantiques adjacentes ;
- plusieurs premières grilles de commande, disposées les unes à côté des autres du côté d'une première face de la couche semi-conductrice, recouvrant au moins une partie de la matrice de boîtes quantiques et/ou des régions de couplage, et configurées pour commander chacune le potentiel électrostatique d'au moins une des boîtes quantiques ou d'au moins une des régions de couplage ;
- plusieurs deuxièmes grilles de commande, disposées les unes à côté des autres du côté d'une deuxième face, opposée à la première face, de la couche semi-conductrice, recouvrant au moins une partie de la matrice de boîtes quantiques et/ou des régions de couplage, et configurées pour commander chacune le potentiel électrostatique d'au moins une des boîtes quantiques ou d'au moins une des régions de couplage ;
dans lequel les premières grilles de commande s'étendent selon leur plus grande dimension parallèlement à un premier axe et les deuxièmes grilles de commande s'étendent selon leur plus grande dimension parallèlement à un deuxième axe, et dans lequel des projections des premier et deuxième axes dans un même plan sont sécantes.

Il est également proposé un dispositif électronique comprenant :
- une couche semi-conductrice comprenant une matrice de boîtes quantiques et des régions de couplage chacune disposée entre deux boîtes quantiques adjacentes ;
- plusieurs premières grilles de commande, disposées les unes à côté des autres du côté d'une première face de la couche semi-conductrice, recouvrant au moins une partie de la matrice de boîtes quantiques et des régions de couplage, et configurées pour commander chacune le potentiel électrostatique d'au moins une des boîtes quantiques ou d'au moins une des régions de couplage ;
- plusieurs deuxièmes grilles de commande, disposées les unes à côté des autres du côté d'une deuxième face, opposée à la première face, de la couche semi-conductrice, recouvrant au moins une partie de la matrice de boîtes quantiques et des régions de couplage, et configurées pour commander chacune le potentiel électrostatique d'au moins une des boîtes quantiques ou d'au moins une des régions de couplage ;
dans lequel les premières grilles de commande s'étendent selon leur plus grande dimension parallèlement à un premier axe et les deuxièmes grilles de commande s'étendent selon leur plus grande dimension parallèlement à un deuxième axe, dans lequel des projections des premier et deuxième axes dans un même plan sont sécantes, dans lequel chacune des boîtes quantiques est disposée en regard d'une des premières grilles de commande et d'une des deuxièmes grilles de commande, et dans lequel chacune des régions de couplage est disposée en regard d'une des premières grilles de commande et d'une des deuxièmes grilles de commande.

Selon un mode de réalisation particulier, les premières et deuxièmes grilles de commande sont configurées telles que, pour chacune des régions de couplage, la première grille de commande disposée en regard de ladite région de couplage soit adjacente aux premières grilles de commande disposées en regard des deux boîtes quantiques voisines destinées à être couplées l'une à l'autre par ladite région de couplage, et que la deuxième grille de commande disposée en regard de ladite région de couplage soit adjacente aux deuxièmes grilles de commande disposées en regard desdites deux boîtes quantiques.

Selon un mode de réalisation particulier, les premières grilles de commande sont alignées selon une première direction perpendiculaire à une deuxième direction selon laquelle les deuxièmes grilles de commande sont alignées.

Selon un mode de réalisation particulier, la couche semi-conductrice comporte des trous la traversant et qui sont disposés chacun entre deux boîtes quantiques adjacentes disposées en regard d'une même première grille de commande et/ou entre deux boîtes quantiques adjacentes disposées en regard d'une même deuxième grille de commande.

Selon un mode de réalisation particulier, chaque trou est disposé en regard d'une première grille de commande et d'une deuxième grille de commande chacune configurée pour commander le potentiel électrostatique d'au moins une des boîtes quantiques.

Selon un mode de réalisation particulier, le dispositif électronique comporte en outre des premiers éléments de contact électrique couplés aux premières grilles de commande et des deuxièmes éléments de contact électrique couplé aux deuxièmes grilles de commande, et les premiers et deuxièmes éléments de contact électrique sont disposés au niveau d'une même face du dispositif électronique.

Selon un mode de réalisation particulier, des premiers éléments de contact électrique sont couplés à des extrémités de premières portions conductrices des premières grilles de commande et disposées à des distances différentes par rapport à un premier bord de la couche semi-conductrice, et/ou des deuxièmes éléments de contact électrique sont couplés à des extrémités de deuxièmes portions conductrices des deuxièmes grilles de commande et disposées à des distances différentes par rapport à un deuxième bord de la couche semi-conductrice.

Il est également proposé un procédé de réalisation d'un dispositif électronique, comportant au moins les étapes suivantes :
- réalisation de plusieurs premières grilles de commande disposées les unes à côté des autres du côté d'une première face d'une couche semi-conductrice comprenant une matrice de boîtes quantiques et des régions de couplage chacune disposée entre deux boîtes quantiques adjacentes, recouvrant au moins une partie de la matrice de boîtes quantiques et/ou des régions de couplage, et configurées pour commander chacune le potentiel électrostatique d'au moins une des boîtes quantiques ou d'au moins une des régions de couplage ;
- réalisation de plusieurs deuxièmes grilles de commande, disposées les unes à côté des autres du côté d'une deuxième face, opposée à la première face, de la couche semi-conductrice, recouvrant au moins une partie de la matrice de boîtes quantiques et/ou des régions de couplage, et configurées pour commander chacune le potentiel électrostatique d'au moins une des boîtes quantiques ou d'au moins une des régions de couplage ;
dans lequel les premières grilles de commande s'étendent selon leur plus grande dimension parallèlement à un premier axe et les deuxièmes grilles de commande s'étendent selon leur plus grande dimension parallèlement à un deuxième axe, et dans lequel des projections des premier et deuxième axes dans un même plan sont sécantes.

Il est également proposé un procédé de réalisation d'un dispositif électronique, comportant au moins les étapes suivantes :
- réalisation de plusieurs premières grilles de commande disposées les unes à côté des autres du côté d'une première face d'une couche semi-conductrice comprenant une matrice de boîtes quantiques et des régions de couplage chacune disposée entre deux boîtes quantiques adjacentes, recouvrant au moins une partie de la matrice de boîtes quantiques et des régions de couplage, et configurées pour commander chacune le potentiel électrostatique d'au moins une des boîtes quantiques ou d'au moins une des régions de couplage ;
- réalisation de plusieurs deuxièmes grilles de commande, disposées les unes à côté des autres du côté d'une deuxième face, opposée à la première face, de la couche semi-conductrice, recouvrant au moins une partie de la matrice de boîtes quantiques et des régions de couplage, et configurées pour commander chacune le potentiel électrostatique d'au moins une des boîtes quantiques ou d'au moins une des régions de couplage ;
dans lequel les premières grilles de commande s'étendent selon leur plus grande dimension parallèlement à un premier axe et les deuxièmes grilles de commande s'étendent selon leur plus grande dimension parallèlement à un deuxième axe, dans lequel des projections des premier et deuxième axes dans un même plan sont sécantes, dans lequel chacune des boîtes quantiques est disposée en regard d'une des premières grilles de commande et d'une des deuxièmes grilles de commande, et dans lequel chacune des régions de couplage est disposée en regard d'une des premières grilles de commande et d'une des deuxièmes grilles de commande.

Selon un mode de réalisation particulier, le procédé comporte en outre, entre la réalisation des premières grilles de commande et la réalisation des deuxièmes grilles de commande, une réalisation de trous traversant la couche semi-conductrice et chacun disposé entre deux boîtes quantiques adjacentes disposées en regard d'une même première grille de commande et/ou entre deux boîtes quantiques adjacentes disposées en regard d'une même deuxième grille de commande.

Selon un mode de réalisation particulier, la couche semi-conductrice correspond à au moins une partie d'une couche superficielle d'un substrat de type semi-conducteur sur isolant.

Selon un mode de réalisation particulier, la réalisation des premières grilles de commande comporte au moins la mise en œuvre des étapes suivantes :
- réalisation d'au moins une première couche diélectrique et d'une première couche conductrice sur la couche superficielle ;
- gravure de la première couche conductrice telle que les portions restantes de la première couche conductrice et la première couche diélectrique forment les premières grilles de commande.

Selon un mode de réalisation particulier, le procédé peut comporter en outre, entre la réalisation des premières grilles de commande et la réalisation des deuxièmes grilles de commande, la mise en œuvre des étapes suivantes :
- réalisation d'une première couche d'encapsulation recouvrant au moins les premières grilles de commande ;
- solidarisation d'une couche de maintien mécanique sur la première couche d'encapsulation ;
- retrait d'une couche support et d'une couche diélectrique enterrée du substrat, révélant une deuxième face de la couche superficielle correspondant à la deuxième face de la couche semi-conductrice.

Selon un mode de réalisation particulier, le procédé comporte en outre, entre le retrait de la couche support et de la couche diélectrique enterrée et la réalisation des deuxièmes grilles de commande, une étape de gravure d'une partie de la couche superficielle telle qu'une portion restante de la couche superficielle forme la couche semi-conductrice, ou une oxydation d'une partie de la couche superficielle telle qu'une portion non oxydée de la couche superficielle forme la couche semi-conductrice.

Selon un mode de réalisation particulier, la réalisation des deuxièmes grilles de commande comporte au moins la mise en œuvre des étapes suivantes :
- réalisation d'au moins une deuxième couche diélectrique et d'une deuxième couche conductrice sur la deuxième face de la couche superficielle ;
- gravure de la deuxième couche conductrice et de la deuxième couche diélectrique telle que les portions restantes de la deuxième couche conductrice et de la deuxième couche diélectrique forment les deuxièmes grilles de commande.

Selon un mode de réalisation particulier, le procédé comporte en outre la réalisation de premiers éléments de contact électrique couplés aux premières grilles de commande à travers la première couche d'encapsulation, et la réalisation de deuxièmes éléments de contact électrique couplés aux deuxièmes grilles de commande à travers une deuxième couche d'encapsulation préalablement déposée et recouvrant les deuxièmes grilles de commande.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
- la figure 1, la figure 2, la figure 3 et la figure 4 représentent différentes vues schématiques d'un dispositif électronique selon un mode de réalisation particulier ;
- la figure 5A, la figure 5B, la figure 6A, la figure 6B, la figure 7A, la figure 7B, la figure 8A, la figure 8B, la figure 9A, la figure 9B, la figure 10A, la figure 10B, la figure 11A, la figure 11B, la figure 12A, la figure 12B, la figure 13A, la figure 13B, la figure 14A et la figure 14B représentent des étapes d'un procédé de réalisation d'un dispositif électronique selon un mode de réalisation particulier.

### Description des modes de réalisation

De mêmes éléments ont été désignés par de mêmes références dans les différentes figures. En particulier, les éléments structurels et/ou fonctionnels communs aux différents exemples et modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments. En outre, dans tout le texte, les termes « couplé » et « couplage » sont utilisés pour désigner un couplage électrique entre au moins deux éléments. De même, le terme « conducteur » est utilisé pour désigner une conduction électrique. Dans le cas d'un couplage tunnel, le terme « couplage » fait référence à un recouvrement de fonctions d'ondes de particules.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", "latéral", etc., ou à des qualificatifs d'orientation, tels que les termes "horizontal", "vertical", "diagonal", etc., il est fait référence sauf précision contraire à l'orientation telle que représentée sur les figures dans une position normale d'utilisation. Toutefois, ces termes ne présument pas de la position et de l'orientation réelles du dispositif lors de son utilisation ou de sa fabrication.

Dans tout le document, les termes « ligne » et « colonne » sont utilisés en considérant une orientation arbitraire du dispositif décrit, ces termes pouvant être intervertis suivant la disposition du dispositif dans l'espace.

Sauf précision contraire, les expressions "environ", "approximativement", "sensiblement", et "de l'ordre de" signifient à 10 % ou à 10° près, de préférence à 5 % ou à 5° près.

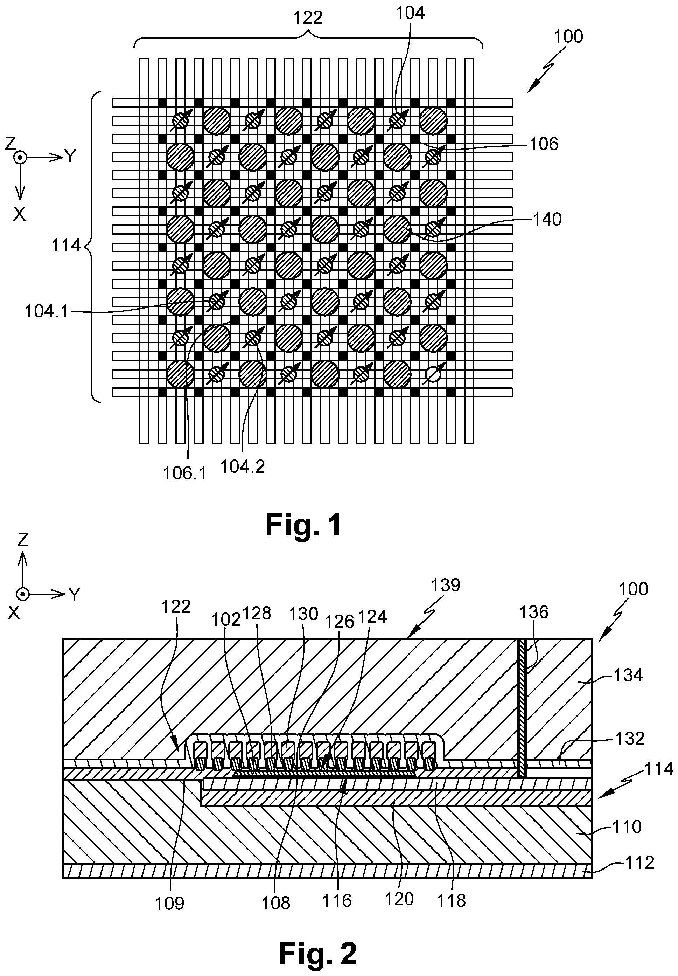

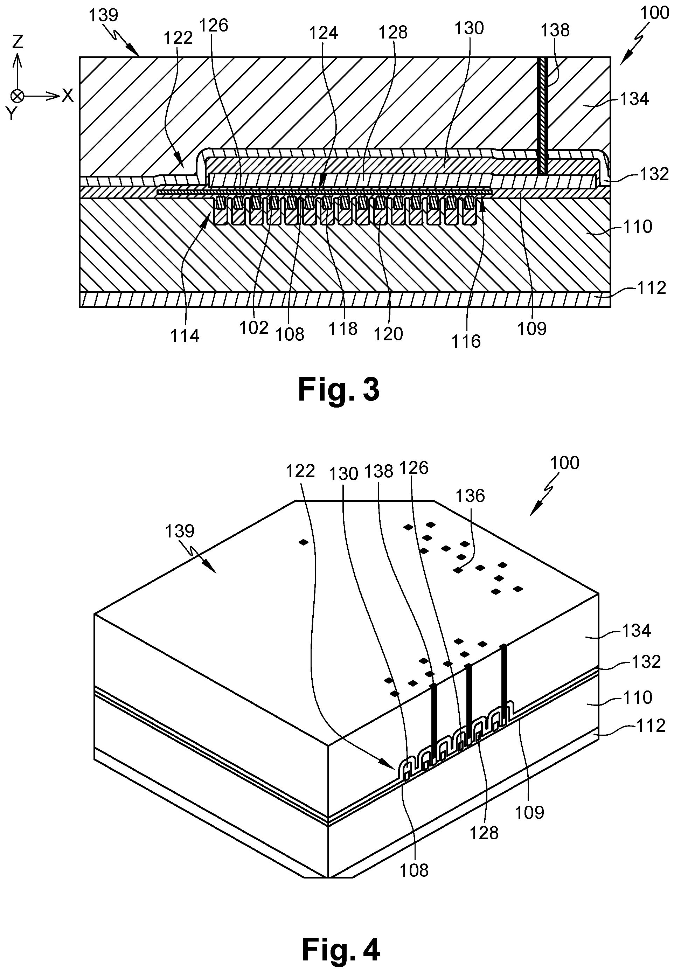

Un exemple d'un dispositif électronique 100 selon un mode de réalisation particulier est décrit ci-dessous en lien avec la figure 1 qui est une vue de dessus schématique de la matrice de boîtes quantiques et de régions de couplage du dispositif 100, avec les figures 2 et 3 qui sont des vues en coupe schématiques du dispositif 100, et avec la figure 4 qui est une vue en perspective schématique du dispositif 100.

Le dispositif 100 comporte une couche semi-conductrice 102 configurée pour former une matrice de boîtes quantiques 104 et de régions de couplage, ou barrières tunnel, 106. Chacune des régions de couplage 106 est disposée entre deux boîtes quantiques 102 voisines, ou adjacentes, et disposées, sur l'exemple de la figure 1, en diagonale.

Par exemple, la couche semi-conductrice 102 peut comporter du silicium, ou tout autre semi-conducteur adapté à la formation des boîtes quantiques 104 et des régions de couplage 106 en son sein. L'épaisseur de la couche semi-conductrice 102 (dimension parallèle à l'axe Z sur l'exemple des figures 1 à 4) peut être comprise entre 10 nm et 15 nm.

Dans l'exemple de réalisation décrit, la couche semi-conductrice 102 est disposée sur un support formé d'une première couche diélectrique 108, d'une couche d'oxyde 109 (se confondant visuellement avec la première couche diélectrique 108 sur les figures 2 à 4), d'une première couche d'encapsulation 110 et d'une couche de maintien mécanique 112. La première couche d'encapsulation 110 est disposée entre la couche d'oxyde 109 et la couche de maintien mécanique 112, et la couche d'oxyde 109 est disposée entre la première couche diélectrique 108 et la couche d'encapsulation 110. Par exemple, la première couche diélectrique 108 peut comporter de l'oxyde de silicium, ou tout autre matériau diélectrique adapté à la formation d'un oxyde de grille, et son épaisseur (dimension parallèle à l'axe Z sur l'exemple des figures 2 à 4) peut être comprise entre 3 nm et 10 nm. La couche d'oxyde 109 peut comporter par exemple de l'oxyde de silicium et son épaisseur peut être égale à 5 nm ou plus généralement comprise entre 5 nm et 15 nm. La première couche d'encapsulation 110 peut comporter au moins un matériau diélectrique tel que de l'oxyde de silicium et son épaisseur (dimension parallèle à l'axe Z sur l'exemple des figures 2 à 4) peut être comprise entre 100 nm et 200 nm. La couche de maintien mécanique 112 peut comporter du silicium et son épaisseur (dimension parallèle à l'axe Z sur l'exemple des figures 2 à 4) peut être par exemple égale à 725 µm.

La couche d'oxyde 109 est une couche optionnelle permettant d'espacer la couche d'encapsulation 110 vis-à-vis de la couche semi-conductrice 102. Un tel espacement peut être avantageux lorsque le ou les matériaux utilisés pour former la couche d'encapsulation 110 contiennent des défauts chargés qu'il est préférable de ne pas avoir au plus proche des qubits. Néanmoins, le dispositif 100 peut ne pas comporter cette couche d'oxyde 109.

Sur les figures 2 à 4, bien que la première couche d'encapsulation 110 soit représentée comme étant plus épaisse que la couche de maintien mécanique 112, cette dernière peut être en réalité plus épaisse que la première couche d'encapsulation 110.

Le dispositif 100 comporte en outre plusieurs premières grilles de commande 114 disposées les unes à côté des autres du côté d'une première face 116 de la couche semi-conductrice 102. Dans l'exemple représenté sur les figures 1 à 4, les premières grilles de commande 114 sont formées par des portions de matériaux s'étendant sensiblement parallèlement à l'axe Y, c'est-à-dire comportant leur longueur, ou leur plus grande dimension, parallèle à l'axe Y. Sur l'exemple de la figure 1, les premières grilles de commande 114 forment plusieurs lignes s'étendant parallèlement les unes aux autres.

Les premières grilles de commande 114 sont configurées pour commander chacune le potentiel électrostatique d'au moins une des boîtes quantiques 104 ou d'au moins une des régions de couplage 106. Dans l'exemple des figures 1 à 4, compte tenu des dimensions de la matrice de boîtes quantiques 104 et de régions de couplage 106 et du nombre important de boîtes quantiques 104 et de régions de couplage 106, chacune des premières grilles de commande 114 est configurée pour commander le potentiel électrostatique de plusieurs boîtes quantiques 104 disposées sur une même ligne de la matrice ou de plusieurs régions de couplage 106 disposées sur une même ligne de la matrice.

En outre, dans l'exemple représenté sur les figures 1 à 4, chacune des premières grilles de commande 114 qui est configurée pour commander le potentiel électrostatique de plusieurs régions de couplage 106 est disposée entre deux autres premières grilles de commande 114 qui lui sont adjacentes et qui sont configurées pour commander le potentiel électrostatique de plusieurs boîtes quantiques 104. De plus, dans cet exemple, chaque paire de premières grilles de commande 114 configurées pour commander le potentiel électrostatique de boîtes quantiques 104 disposées sur deux lignes voisines de boîtes quantiques 104 sont séparées l'une de l'autre par une première grille de commande 114 configurée pour commander le potentiel électrique de régions de couplage 106 destinées à commander le couplage, ou les barrières tunnel, entre ces boîtes quantiques 104. Ainsi, dans l'exemple décrit en lien avec les figures 1 à 4, parallèlement à l'axe X, c'est-à-dire perpendiculairement à la direction selon laquelle s'étendent les premières grilles de commande 114, celles configurées pour commander le potentiel électrostatique des boîtes quantiques 104 et celles configurées pour commander le potentiel électrostatique des régions de couplage 106 sont disposées de manière alternée les unes à côté des autres.

Chacune des premières grilles de commande 114 comporte un diélectrique de grille qui, dans l'exemple décrit en lien avec les figures 2 à 4, est formé par la première couche diélectrique 108.

De plus, dans l'exemple décrit, chacune des premières grilles de commande 114 comporte en outre une première portion conductrice 118 disposée contre la première couche diélectrique 108. Chacune des premières portions conductrices 118 a par exemple une forme allongée s'étendant sensiblement parallèlement à l'axe Y. Les premières portions conductrices 118 peuvent comporter par exemple du polysilicium ou tout autre matériau conducteur adapté à la formation de conducteurs de grilles. Chacune des premières portions conductrices 118 a par exemple une largeur (qui correspond à la plus petite dimension de chacune des portions conductrices 118 dans un plan parallèle à la première face 116 de la couche semi-conductrice 102) comprise entre 15 nm et 30 nm, et une longueur (qui correspond à la plus grande dimension de chacune des portions conductrices 118 dans un plan parallèle à la première face 116 de la couche semi-conductrice 102) qui dépend des dimensions de la matrice de boîtes quantiques 104 et de régions de couplage 106. De plus, chacune des premières portions conductrices 118 a par exemple une épaisseur, ou hauteur (qui correspond à la dimension perpendiculaire à la première face 116 de la couche semi-conductrice 102) comprise entre 15 nm et 30 nm.

Dans l'exemple de réalisation représenté sur les figures 2 à 4, des premières portions diélectriques 120 sont disposées contre les premières portions conductrices 118 telles que chacune des premières portions conductrices 118 soit disposée entre la première couche diélectrique 108 et l'une des premières portions diélectriques 120. Ces premières portions diélectriques 120 correspondent au masque utilisé pour la réalisation des premières portions conductrices 118 et comportent par exemple du nitrure de silicium.

En variante, le dispositif 100 peut ne pas comporter ces premières portions diélectriques 120, par exemple lorsque le masque de gravure est retiré après la gravure formant les premières portions conductrices 118.

Dans l'exemple de réalisation représenté sur les figures 2 à 4, les premières grilles de commande 114 sont encapsulées dans la première couche d'encapsulation 110 qui recouvre les premières portions conductrices 118, les premières portions diélectriques 120 et éventuellement la couche d'oxyde 109.

Le dispositif 100 comporte en outre plusieurs deuxièmes grilles de commande 122 disposées les unes à côté des autres du côté d'une deuxième face 124 de la couche semi-conductrice 102. Dans l'exemple représenté sur les figures 1 à 4, les deuxièmes grilles de commande 122 sont formées par des portions de matériaux s'étendant sensiblement parallèlement à l'axe X. Ainsi, dans l'exemple décrit, les premières grilles de commande 114 sont alignées selon une première direction, ou orientation, sensiblement perpendiculaire à une deuxième direction, ou orientation, selon laquelle les deuxièmes grilles de commande 122 sont alignées. En variante, l'angle formé entre les directions d'alignement des premières et deuxièmes grilles de commande 114, 122 peut ne pas être un angle droit, mais dans tous les cas cet angle n'est pas nul. Autrement dit, les premières grilles de commande 114 s'étendent selon leur plus grande dimension parallèlement à un premier axe et les deuxièmes grilles de commande 122 s'étendent selon leur plus grande dimension parallèlement à un deuxième axe, et des projections des premier et deuxième axes dans un même plan sont sécantes (et donc nécessairement non confondues).

Comme les premières grilles de commande 114, les deuxièmes grilles de commande 122 sont configurées pour commander chacune le potentiel électrostatique d'au moins une des boîtes quantiques 104 ou d'au moins une des régions de couplage 106. Dans l'exemple des figures 1 à 4, compte tenu des dimensions de la matrice de boîtes quantiques 104 et de régions de couplage 106 et du nombre important de boîtes quantiques 104 et de régions de couplage 106, chacune des deuxièmes grilles de commande 122 est configurée pour commander le potentiel électrostatique de plusieurs boîtes quantiques 104 ou de plusieurs régions de couplage 106.

En outre, dans l'exemple représenté sur les figures 1 à 4, chacune des deuxièmes grilles de commande 122 qui est configurée pour commander le potentiel électrostatique de plusieurs régions de couplage 106 est disposée entre deux autres deuxièmes grilles de commande 122 qui lui sont adjacentes et qui sont configurées pour commander le potentiel électrostatique de plusieurs boîtes quantiques 104. De plus, dans cet exemple, chaque paire de deuxièmes grilles de commande 122 configurées pour commander le potentiel électrostatique de boîtes quantiques 104 disposées sur deux colonnes voisines de boîtes quantiques 104 sont séparées l'une de l'autre par une deuxième grille de commande 122 configurée pour commander le potentiel électrique de régions de couplage 106 destinées à commander le couplage, ou les barrières tunnel, entre ces boîtes quantiques 104. Ainsi, dans l'exemple décrit en lien avec les figures 1 à 4, parallèlement à l'axe Y, c'est-à-dire perpendiculairement à la direction selon laquelle s'étendent les deuxièmes grilles de commande 122, celles configurées pour commander le potentiel électrostatique des boîtes quantiques 104 et celles configurées pour commander le potentiel électrostatique des régions de couplage 106 sont disposées de manière alternée les unes à côté des autres.

Chacune des deuxièmes grilles de commande 122 peut comporter un diélectrique de grille qui, dans l'exemple décrit en lien avec les figures 1 à 4, est formé par une deuxième couche diélectrique 126 recouvrant la deuxième face 124 de la couche semi-conductrice 102 et qui peut également être en contact avec des parties de la première couche diélectrique 108 se trouvant à côté de la couche semi-conductrice 102 ou avec des parties d'une autre couche d'oxyde lorsque la couche semi-conductrice 102 est formée par oxydation de certaines parties d'une couche semi-conductrice. Par exemple, la deuxième couche diélectrique 126 peut comporter de l'oxyde de silicium ou tout autre matériau diélectrique adapté à la formation d'un oxyde de grille, et son épaisseur (dimension parallèle à l'axe Z sur l'exemple des figures 2 à 4) peut être comprise entre 3 nm et 10 nm.

De plus, dans l'exemple décrit, chacune des deuxièmes grilles de commande 122 comporte en outre une deuxième portion conductrice 128 disposée contre la deuxième couche diélectrique 126. Chacune des deuxièmes portions conductrices 128 a par exemple une forme allongée s'étendant sensiblement parallèlement à l'axe X. Les deuxièmes portions conductrices 128 peuvent comporter par exemple du polysilicium ou tout autre matériau conducteur adapté à la formation de conducteurs de grille. Les dimensions des deuxièmes portions conductrices 128 peuvent être similaires à celles indiquées précédemment pour les premières portions conductrices 118.

Le pitch des premières grilles de commande 114, qui correspond à la distance entre les axes longitudinaux de deux premières portions conductrices 118 adjacentes, peut être compris entre 30 nm et 40 nm. Le pitch des deuxièmes grilles de commande 122 peut être similaire à celui des premières grilles de commande 114. Par exemple, en réalisant les premières et deuxièmes grilles de commande 114, 122 avec un pitch égal à 35 nm, la distance entre deux boîtes quantiques 104 destinées à interagir l'une avec l'autre lors d'une opération de code de correction d'erreur peut être égale à environ 100 nm.

Dans l'exemple de réalisation représenté sur les figures 2 à 4, des deuxièmes portions diélectriques 130 sont disposées contre les deuxièmes portions conductrices 128 telles que chacune des deuxièmes portions conductrices 128 soit disposée entre la deuxième couche diélectrique 126 et l'une des deuxièmes portions diélectriques 130. Ces deuxièmes portions diélectriques 130 correspondent au masque utilisé pour la réalisation des deuxièmes portions conductrices 128 et comportent par exemple du nitrure de silicium ou de l'oxyde de silicium. En variante, le dispositif 100 peut ne pas comporter ces deuxièmes portions diélectriques 130, par exemple lorsque le masque de gravure est retiré après la gravure formant les deuxièmes portions conductrices 128.

Dans l'exemple de réalisation décrit, les deuxièmes grilles de commande 122 et les parties de la deuxième couche diélectrique 126 non recouvertes par les deuxièmes grilles de commande 122 sont recouvertes par une couche d'arrêt de gravure 132, ou CESL (« Contact Etch Stop Layer » en anglais) . La couche d'arrêt de gravure 132 comporte par exemple du nitrure de silicium et son épaisseur est par exemple comprise entre 20 nm et 30 nm. Sur l'exemple des figures 2 à 4, le dispositif 100 comporte en outre une deuxième couche d'encapsulation 134 qui recouvre la couche d'arrêt de gravure 132, qui comporte un matériau diélectrique correspondant par exemple à de l'oxyde de silicium et dont l'épaisseur (dimension parallèle à l'axe Z sur les figures 2 à 4) est par exemple comprise entre 100 nm et 200 nm.

Dans l'exemple de réalisation décrit, le dispositif 100 comporte en outre des premiers éléments de contact électrique 136 traversant la deuxième couche d'encapsulation 134, la couche d'arrêt de gravure 132 et les première et deuxième couches diélectriques 108, 126, et formant chacun un accès électrique à l'une des premières grilles de commande 114. Dans l'exemple décrit, le dispositif 100 comporte également des deuxièmes éléments de contact électrique 138 traversant la deuxième couche d'encapsulation 134, la couche d'arrêt de gravure 132 et les deuxièmes portions diélectriques 130, et formant chacun un accès électrique à l'une des deuxièmes grilles de commande 122. Ces premiers et deuxièmes éléments de contact électrique 136, 138 sont disposés au niveau d'une même face du dispositif 100 (du côté de la deuxième face 124 de la couche semi-conductrice 102 sur l'exemple des figures 2 à 4). Dans l'exemple décrit en lien avec les figures 2 à 4, les éléments de contact électrique 136, 138 débouchent au niveau d'une face supérieure 139 de la deuxième couche d'encapsulation 134.

Dans une configuration particulière correspondant à celle représentée sur les figures 2 à 4, des extrémités des premières portions conductrices 118 sont disposées à des distances différentes par rapport à un premier bord de la couche semi-conductrice 102. De plus, des extrémités des deuxièmes portions conductrices 128 sont disposées à des distances différentes par rapport à un deuxième bord de la couche semi-conductrice 102. Une telle configuration facilite la réalisation des premiers et/ou deuxièmes éléments de contact électrique 136, 138 qui viennent en contact avec les premières et/ou deuxièmes portions conductrices 118, 128 au niveau de ces extrémités. En effet, avec de telles distances différentes entre les extrémités des portions conductrices 118, 128 et les bords de la couche semi-conductrice 102, il est possible qu'un ou plusieurs des éléments de contact électrique 136, 138 soit plus large que les portions conductrices 118, 128 sans que cela entraîne un court-circuit entre des portions conductrices 118, 128 adjacentes ou voisines.

Les premières et deuxièmes grilles de commande 114, 122 sont configurées telles que chacune des boîtes quantiques 104 soit disposée en regard d'une des premières grilles de commande 114 et d'une des deuxièmes grilles de commande 122, et que chacune des régions de couplage 106 soit disposée en regard d'une des premières grilles de commande 114 et d'une des deuxièmes grilles de commande 122. En outre, la projection de chacune des premières grilles de commande 114 dans un plan parallèle aux première et deuxième faces 116, 124 de la couche semi-conductrice 102 croise les projections de chacune des deuxièmes grilles de commande 122 dans ledit plan. Dans l'exemple décrit, ce croisement forme des angles droits entre les projections des premières grilles de commande 114 et celles des deuxièmes grilles de commande 122.

Dans l'exemple de réalisation décrit, les premières et deuxièmes grilles de commande 114, 122 sont configurées telles que, pour chacune des régions de couplage 106, la première grille de commande 114 disposée en regard de ladite région de couplage 106 soit adjacente aux premières grilles de commande 114 disposées en regard des deux boîtes quantiques 104 voisines, ou adjacentes, destinées à être couplées l'une à l'autre par ladite région de couplage 106, et que la deuxième grille de commande 122 disposée en regard de ladite région de couplage 106 soit adjacente aux deuxièmes grilles de commande 122 disposées en regard desdites deux boîtes quantiques 104.

En outre, dans l'exemple de réalisation décrit en lien avec les figures 1 à 4, le dispositif 100 comporte en outre des trous 140 traversant la couche semi-conductrice 102 et qui sont disposés chacun entre deux boîtes quantiques 104 voisines disposées en regard d'une même première grille de commande 114 et/ou entre deux boîtes quantiques 104 voisines disposées en regard d'une même deuxième grille de commande 122. De tels trous 140 peuvent faciliter le confinement des charges dans les boîtes quantiques 104 en évitant d'avoir à appliquer un potentiel électrique de confinement là où les trous 140 sont localisés, l'absence de semi-conducteur au niveau des trous 140 permettant d'interdire la présence de charges aux emplacements des trous 140. Dans une configuration particulière correspondant à celle visible sur la figure 1, chaque trou 140 peut être disposé en regard d'une première grille de commande 114 et d'une deuxième grille de commande 122 chacune configurée pour commander le potentiel électrostatique d'au moins une des boîtes quantiques 104. En variante, le dispositif 100 peut ne pas comporter les trous 140, le potentiel électrique des régions non traversées par les trous 140 étant dans ce cas commandé localement par une grille.

La matrice de boîtes quantiques 104 et de régions de couplage 106 du dispositif 100 est telle que le potentiel électrostatique de chaque boîte quantique 104 soit contrôlé par une des premières grilles de commande 114 et une des deuxièmes grilles de commande 122, et que le potentiel électrostatique de chaque région de couplage 106 soit contrôlé par une des premières grilles de commande 114 et une des deuxièmes grilles de commande 122. Pour cela, les premières et deuxièmes grilles de commande 114, 122 sont ici configurées de sorte que chacune des boîtes quantiques 104 soit disposée en regard d'une des premières grilles de commande 114 et d'une des deuxièmes grilles de commande 122, et que chacune des régions de couplage 106 soit disposée en regard d'une des premières grilles de commande 114 et d'une des deuxièmes grilles de commande 122. Les premières grilles de commande 114 contrôlant le potentiel électrostatique des boîtes quantiques 104 sont distinctes de celles contrôlant le potentiel électrostatique des régions de couplage 106. De même, les deuxièmes grilles de commande 122 contrôlant le potentiel électrostatique des boîtes quantiques 104 sont distinctes de celles contrôlant le potentiel électrostatique des régions de couplage 106.

Dans la matrice représentée sur la figure 1, les opérations de correction d'erreur, par exemple de code de surface, entre qubits sont donc réalisées au sein des paires de boîtes quantiques 104 voisines agencées en diagonale. Par exemple, sur la figure 1, une opération est réalisable entre les boîtes quantiques désignées par les références 104.1 et 104.2 entre lesquelles le couplage est commandé par la région de couplage désignée par la référence 106.1. Ainsi, l'agencement des boîtes quantiques 104 et des régions de couplage 106 proposé par le dispositif 100 est tel qu'il n'est pas nécessaire de mettre en œuvre des déplacements cohérents entre boîtes quantiques avant de mettre en œuvre des opérations de correction d'erreur entre qubits, du fait que les qubits formés dans les boîtes quantiques 104 sont couplés directement les uns aux autres par les régions de couplage 106.

Le dispositif 100 permet un adressage ligne / colonne des boîtes quantiques 104 et des régions de couplage 106 avec des effets de contrôle au niveau des intersections entre les lignes et les colonnes définies par les premières et deuxièmes grilles de commande 114, 122. Chaque boîte quantique 104 et chaque région de couplage 106 est donc ici contrôlée par deux grilles de commande distinctes. La structure du dispositif 100 permet donc un contrôle individuel et parallèle des boîtes quantiques 104 et des régions de couplage 106. Ainsi, il est possible d'exécuter en parallèle des types de cycle de code de surface différents (par exemple X et Z) dans la matrice de boîtes quantiques 104. En outre, la structure proposée pour le dispositif 100 permet de réaliser un cycle de code de surface avec un nombre d'opérations réduit, indépendamment de la longueur du code (par exemple de l'ordre d'une dizaine d'opérations ou étapes), du fait qu'il n'est pas nécessaire de déplacer les qubits sur lesquels les opérations sont mises en œuvre.

Dans le dispositif 100, du fait que les premières et deuxièmes grilles de commande 114, 122 sont agencées du côté de deux faces 116, 124 opposées de la couche semi-conductrice 102, le dispositif 100 n'est soumis à aucun phénomène d'écrantage des niveaux de grille. Cette disposition évite également les problèmes de gestion de la topographie et/ou des croisements des grilles de commande. Enfin, cette disposition évite la présence d'interface de collage à proximité des boîtes quantiques 104 et des régions de couplage 106.

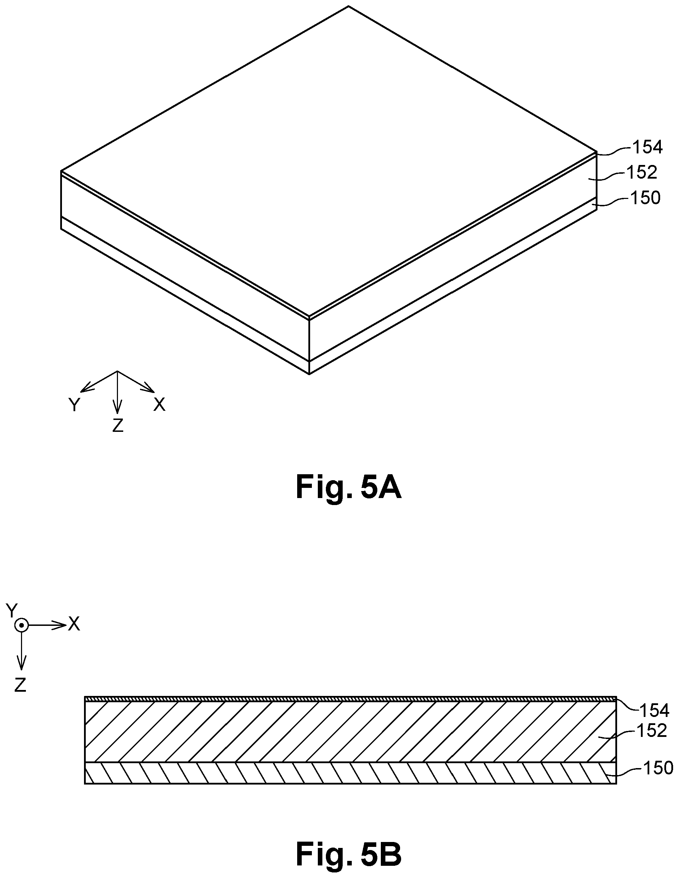

Un exemple de procédé de réalisation du dispositif électronique 100 selon un mode de réalisation particulier est décrit ci-dessous en lien avec les figures 5A à 14B. Les figures 5A, 6A, 7A, 8A, 9A, 10A, 11A, 12A, 13A et 14A correspondent à des vues en perspective des éléments réalisés, et les figures 5B, 6B, 7B, 8B, 9B, 10B, 11B, 12B, 13B et 14B correspondent à des vues en coupe des éléments réalisés.

Dans l'exemple de réalisation décrit, le dispositif 100 est réalisé à partir d'un substrat de type semi-conducteur sur isolant, par exemple SOI (« Silicon on Insulator » en anglais, ou silicium sur isolant). Un tel substrat est représenté sur les figures 5A et 5B, et comporte une couche support 150 comprenant par exemple du silicium, une couche diélectrique enterrée 152, ou BOX (« Buried Oxide » en anglais) comprenant par exemple de l'oxyde de silicium, et une couche superficielle 154 comprenant par exemple du silicium. La couche superficielle 154 est destinée à former la future couche semi-conductrice 102 du dispositif 100. Sur les figures 5A à 8B, bien que la couche diélectrique enterrée 152 soit représentée comme étant plus épaisse que la couche support 150, l'épaisseur de la couche support 150 est en réalité supérieure à celle de la couche diélectrique enterrée 152.

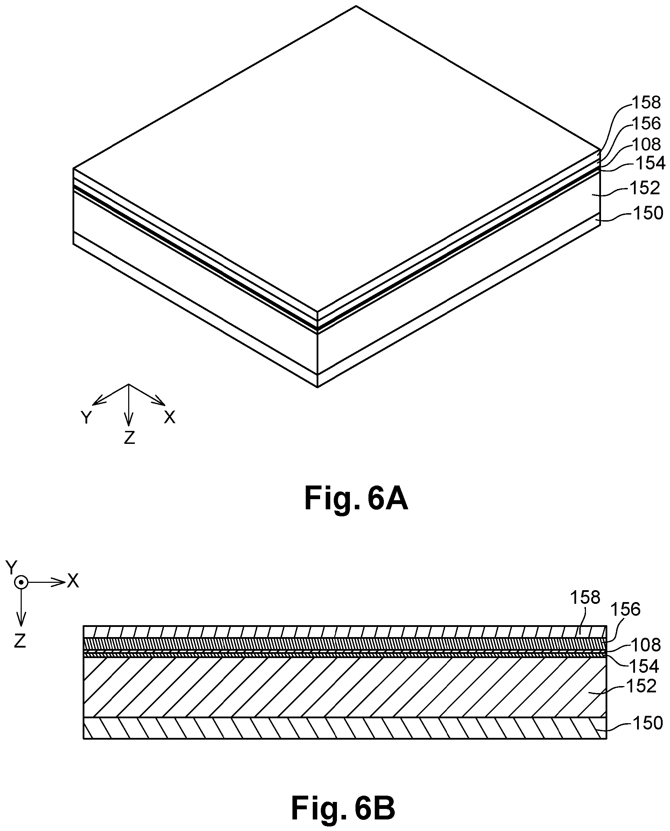

Les premières grilles de commande 114 sont tout d'abord réalisées. Pour cela, dans l'exemple de réalisation décrit, la première couche diélectrique 108 est réalisée, par exemple par dépôt ou par oxydation thermique, sur la couche superficielle 154, puis une première couche conductrice 156 destinée à la réalisation des premières portions conductrices 118 est formée, par exemple par dépôt, sur la première couche diélectrique 108. Une première couche de masque de gravure 158 est ensuite formée, par exemple par dépôt, sur la première couche conductrice 156. La structure obtenue à ce stade du procédé est représentée sur les figures 6A et 6B.

Dans l'exemple de réalisation décrit, une gravure de la première couche conductrice 156 est ensuite mise en œuvre selon un motif défini au préalable dans un masque de gravure réalisé à partir de la première couche de masque de gravure 158. A l'issue de cette gravure, les portions restantes de la première couche conductrice 156 correspondent aux premières portions conductrices 118 et forment, avec la première couche diélectrique 108, les premières grilles de commande 114. Le masque de gravure peut être conservé pour la suite du procédé et forme les premières portions diélectriques 120 disposées sur les premières portions conductrices 118.

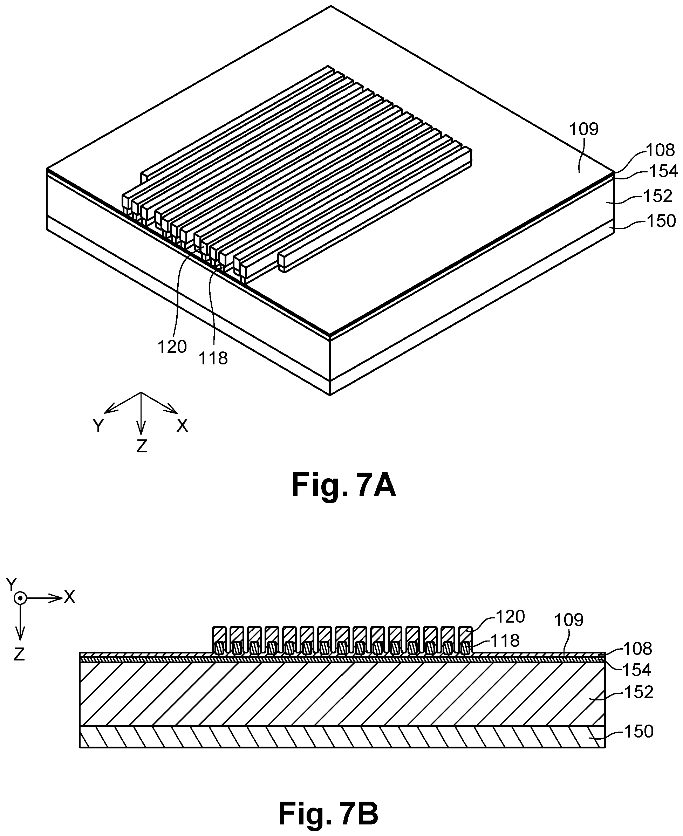

Dans l'exemple de réalisation décrit, la couche d'oxyde 109 est réalisée de manière à recouvrir les parties de la première couche diélectrique 108 non recouvertes par les premières portions conductrices 118. La structure obtenue à ce stade du procédé est représentée sur les figures 7A et 7B. La couche 109 peut par exemple être formée par une étape d'oxydation, ou une étape de dépôt avantageusement suivie d'une étape de traitement thermique pour densification et passivation des défauts chargés. En variante, il est possible de ne pas réaliser cette couche d'oxyde 109.

Dans l'exemple de réalisation décrit, la première couche d'encapsulation 110 est ensuite réalisée, par exemple par dépôt puis planarisation mécano-chimique (ou CMP pour « Chemical Mechanical Polishing » en anglais), en recouvrant notamment les éléments et matériaux précédemment réalisés sur la couche superficielle 154.

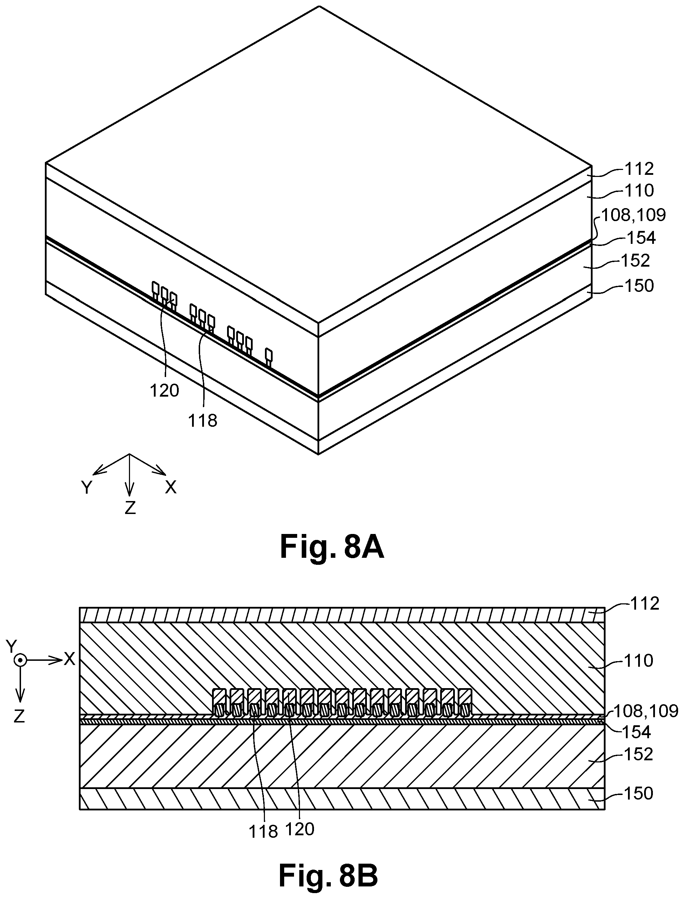

Dans l'exemple de réalisation décrit, la couche de maintien mécanique 112 est ensuite solidarisée sur la première couche d'encapsulation 110. Par exemple, cette solidarisation peut correspondre à un collage direct de type oxyde/oxyde, ce qui implique que la couche de maintien mécanique 112 comporte, au moins au niveau de sa face destinée à être solidarisée à la première couche d'encapsulation 110, de l'oxyde. D'autres types de solidarisation / ou collage sont envisageables. La structure obtenue à ce stade du procédé est représentée sur les figures 8A et 8B.

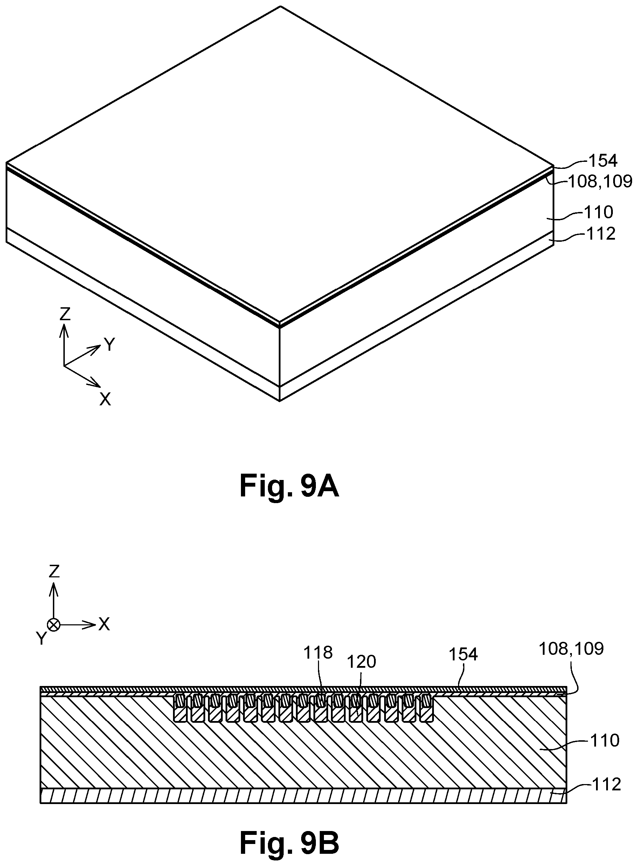

La structure obtenue peut ensuite être retournée. La couche support 150 et la couche diélectrique enterrée 152 sont ensuite retirées, par exemple par meulage (« grinding » en anglais) afin de retirer une majeure partie de l'épaisseur de la couche support 150, puis par gravure(s) humide(s) afin de retirer l'épaisseur restante de la couche support 150 et la couche diélectrique enterrée 152. Ces retraits révèlent la face de la couche superficielle 154 disposée au préalable contre la couche diélectrique enterrée 152. La structure obtenue à ce stade du procédé est représentée sur les figures 9A et 9B.

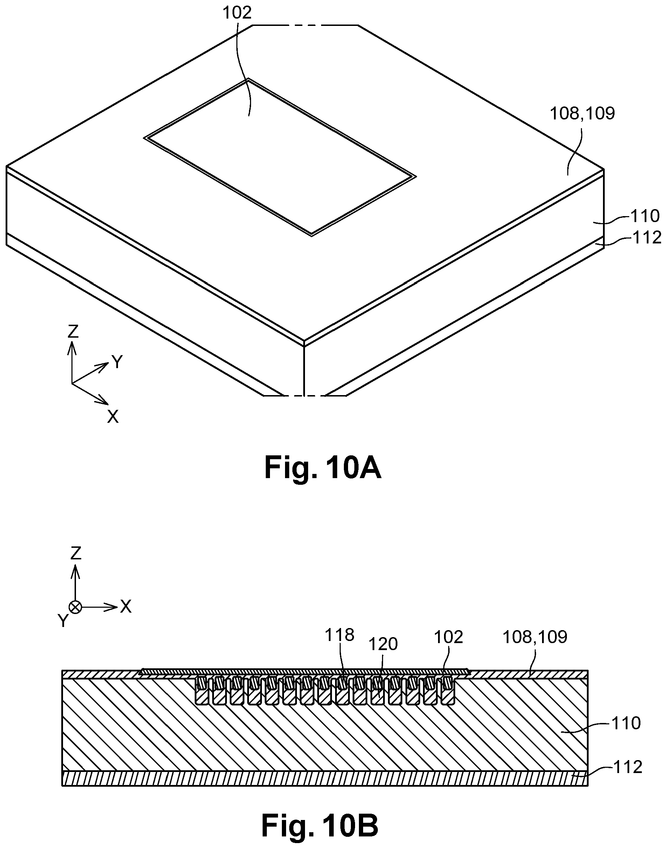

Dans l'exemple de réalisation décrit, une gravure d'une partie de la couche superficielle 154 est mise en œuvre telle qu'une portion restante de la couche superficielle 154 forme la couche semi-conductrice 102 du dispositif 100. La structure obtenue à ce stade du procédé est représentée sur les figures 10A et 10B. En variante, la couche 154 peut être oxydée localement telle que les parties non oxydées forment la couche semi-conductrice 102.

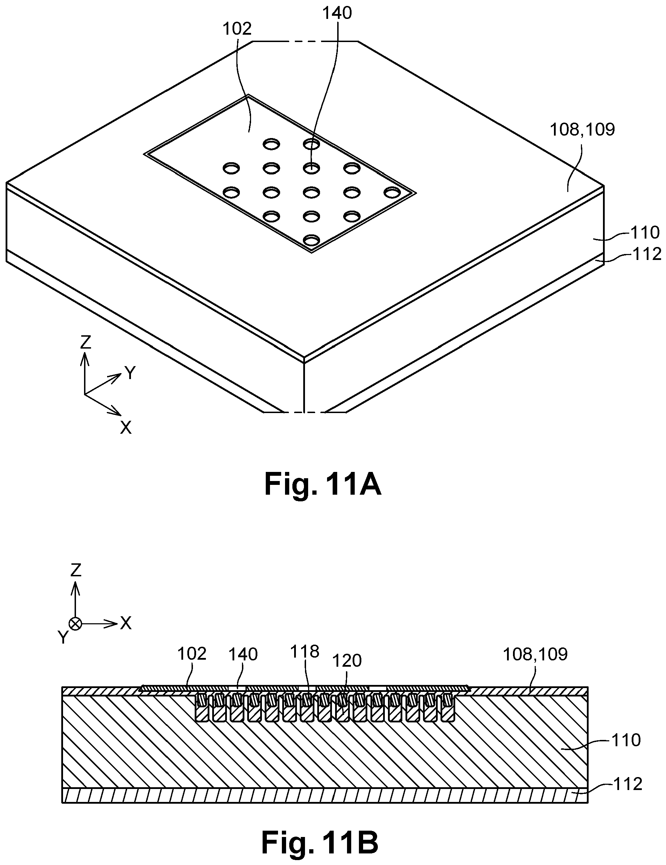

Dans l'exemple de réalisation décrit, les trous 140 sont ensuite réalisés, par exemple par gravure, à travers la couche semi-conductrice 102. La structure obtenue à ce stade du procédé est représentée sur les figures 11A et 11B.

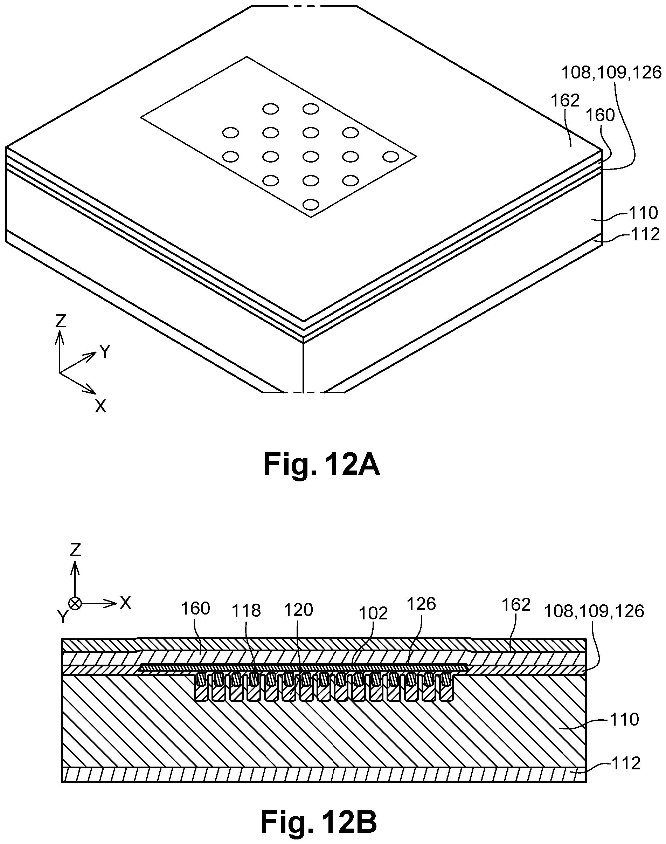

Les deuxièmes grilles de commande 122 sont ensuite réalisées. Pour cela, dans l'exemple de réalisation décrit, la deuxième couche diélectrique 126 est réalisée, par exemple par dépôt, sur la couche semi-conductrice 102 ainsi que sur les parties de la première couche diélectrique 108 non recouvertes par la couche semi-conductrice 102, puis une deuxième couche conductrice 160 destinée à la réalisation des deuxièmes portions conductrices 128 est formée, par exemple par dépôt, sur la deuxième couche diélectrique 126. Une deuxième couche de masque de gravure 162 est ensuite formée, par exemple par dépôt, sur la deuxième couche conductrice 160. La structure obtenue à ce stade du procédé est représentée sur les figures 12A et 12B.

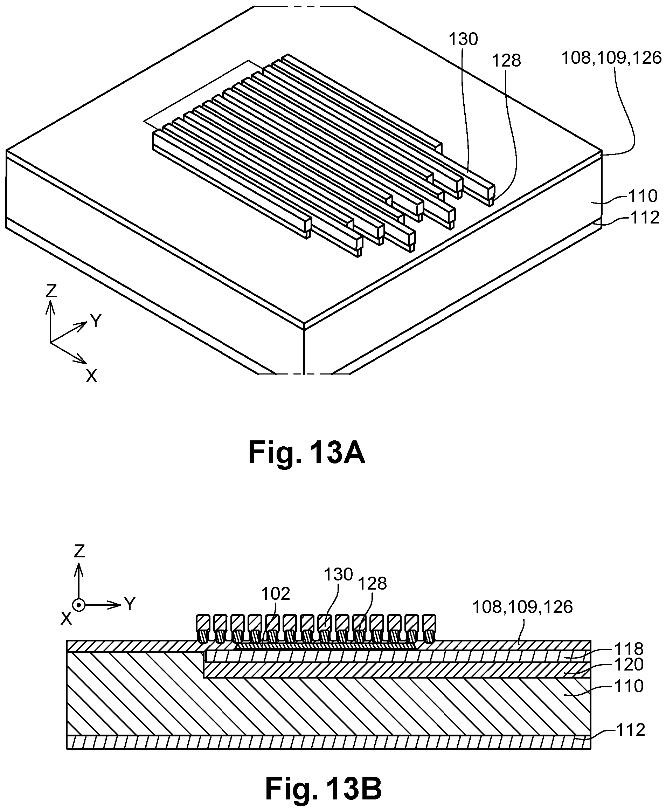

Dans l'exemple de réalisation décrit, une gravure de la deuxième couche conductrice 160 est ensuite mise en œuvre selon un motif défini au préalable dans un masque de gravure réalisé à partir de la deuxième couche de masque de gravure 162. A l'issue de cette gravure, les portions restantes de la deuxième couche conductrice 160 correspondent aux deuxièmes portions conductrices 128 et forment, avec la deuxième couche diélectrique 126, les deuxièmes grilles de commande 122. Le masque de gravure peut être conservé pour la suite du procédé et forme les deuxièmes portions diélectriques 130. De manière optionnelle, une couche d'oxyde similaire à la couche d'oxyde 109 peut être réalisée sur la structure réalisée. La structure obtenue à ce stade du procédé est représentée sur les figures 13A et 13B.

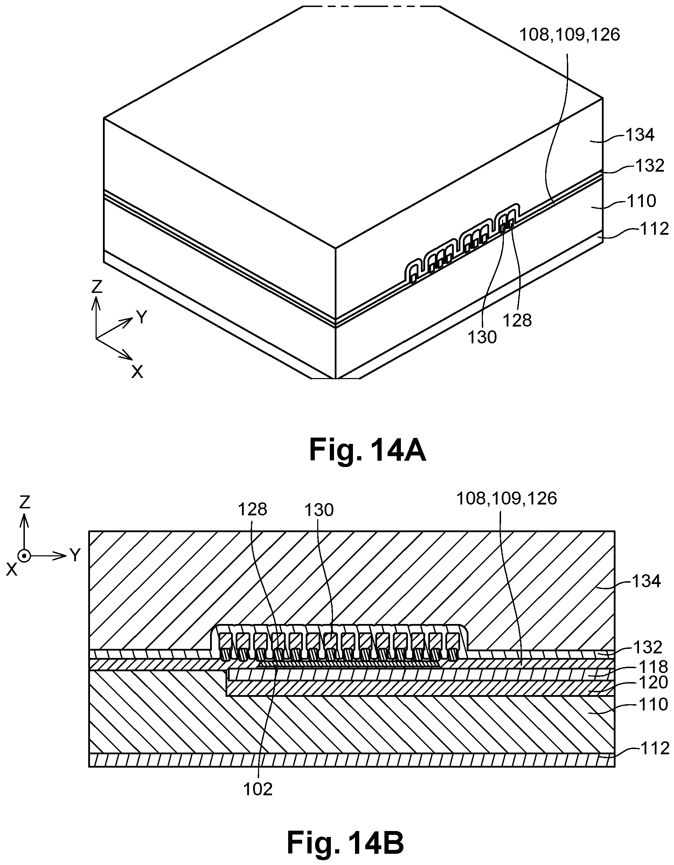

Dans l'exemple de réalisation décrit, la couche d'arrêt de gravure 132 est ensuite réalisée, par exemple par dépôt, en recouvrant les deuxièmes grilles de commande 122 et les parties de la deuxième couche diélectrique 126 non recouvertes par les deuxièmes portions conductrices 128. La deuxième couche d'encapsulation 134 est ensuite réalisée, par exemple par dépôt puis CMP sur la couche d'arrêt de gravure 132. La structure obtenue à ce stade du procédé est représentée sur les figures 14A et 14B.

Enfin, les premiers et deuxièmes éléments de contact électrique 136, 138 sont réalisés à travers les couches recouvrant les premières et deuxièmes portions conductrices 118, 128, c'est-à-dire la deuxième couche d'encapsulation 134, la couche d'arrêt de gravure 132 et la deuxième couche de masque de gravure 166 pour les deuxièmes portions conductrices 128, et également à travers les première et deuxième couches diélectriques 108, 109, 126 pour les premières portions conductrices 118. Pour cela, au moins une étape de lithographie peut être mise en œuvre pour former des trous définissant les emplacements des premiers et deuxièmes éléments de contact électrique 136, 138. Les trous sont ensuite remplis d'au moins un matériau électriquement conducteur pour former les premiers et deuxièmes éléments de contact électrique 136, 138. Le dispositif 100 obtenu correspond à celui visible sur les figures 1 à 4 précédemment décrites.

Dans le dispositif 100, certaines des premières grilles 114 sont dédiées au contrôle des boîtes quantiques 104 et les autres premières grilles 114 sont dédiées au contrôle des régions de couplage 106. De même, certaines des deuxièmes grilles 122 sont dédiées au contrôle des boîtes quantiques 104 et les autres deuxièmes grilles 122 sont dédiées au contrôle des régions de couplage 106. Le fait d'avoir une seule orientation de grille par face, et d'avoir de chaque côté de la structure des grilles dédiées au contrôle des boîtes quantiques et des grilles dédiées au contrôle des régions de couplage, permet d'éviter tout croisement de grille sur une même face de la structure, cet agencement permettant de former l'ensemble des grilles en une seule brique de fabrication, de manière plus simple que lorsque des grilles se croisent sur une même face de la structure. En outre, les premières et deuxièmes grilles 114, 122 ainsi agencées permettent l'obtention d'un effet de commande homogène depuis chacune des faces de la couche semi-conductrice 102.

Divers modes de réalisation et variantes ont été décrits. La personne du métier comprendra que certaines caractéristiques de ces divers modes de réalisation et variantes pourraient être combinées, et d'autres variantes apparaîtront à la personne du métier.

Enfin, la mise en œuvre pratique des modes de réalisation et variantes décrits est à la portée de la personne du métier à partir des indications fonctionnelles données ci-dessus. Par exemple, la nature des dépôts et des gravures mis en œuvre peut être choisie en fonction notamment du ou des matériaux à déposer ou à graver.

## Revendications

1. Dispositif électronique (100) comprenant :
- une couche semi-conductrice (102) comprenant une matrice de boîtes quantiques (104) et des régions de couplage (106) chacune disposée entre deux boîtes quantiques (104) adjacentes ;
- plusieurs premières grilles de commande (114), disposées les unes à côté des autres du côté d'une première face (116) de la couche semi-conductrice (102), recouvrant au moins une partie de la matrice de boîtes quantiques (104) et des régions de couplage (106), et configurées pour commander chacune le potentiel électrostatique d'au moins une des boîtes quantiques (104) ou d'au moins une des régions de couplage (106) ;
- plusieurs deuxièmes grilles de commande (122), disposées les unes à côté des autres du côté d'une deuxième face (124), opposée à la première face (116), de la couche semi-conductrice (102), recouvrant au moins une partie de la matrice de boîtes quantiques (104) et des régions de couplage (106), et configurées pour commander chacune le potentiel électrostatique d'au moins une des boîtes quantiques (104) ou d'au moins une des régions de couplage (106) ;
dans lequel les premières grilles de commande (114) s'étendent selon leur plus grande dimension parallèlement à un premier axe et les deuxièmes grilles de commande (122) s'étendent selon leur plus grande dimension parallèlement à un deuxième axe, dans lequel des projections des premier et deuxième axes dans un même plan sont sécantes, dans lequel chacune des boîtes quantiques (104) est disposée en regard d'une des premières grilles de commande (114) et d'une des deuxièmes grilles de commande (122), et dans lequel chacune des régions de couplage (106) est disposée en regard d'une des premières grilles de commande (114) et d'une des deuxièmes grilles de commande (122).

2. Dispositif électronique (100) selon la revendication 1, dans lequel les premières et deuxièmes grilles de commande (114, 122) sont configurées telles que, pour chacune des régions de couplage (106), la première grille de commande (114) disposée en regard de ladite région de couplage (106) soit adjacente aux premières grilles de commande (114) disposées en regard des deux boîtes quantiques (104) voisines destinées à être couplées l'une à l'autre par ladite région de couplage (106), et que la deuxième grille de commande (122) disposée en regard de ladite région de couplage (106) soit adjacente aux deuxièmes grilles de commande (122) disposées en regard desdites deux boîtes quantiques (104).

3. Dispositif électronique (100) selon l'une quelconque des revendications précédentes, dans lequel les premières grilles de commande (114) sont alignées selon une première direction perpendiculaire à une deuxième direction selon laquelle les deuxièmes grilles de commande (122) sont alignées.

4. Dispositif électronique (100) selon l'une quelconque des revendications précédentes, dans lequel la couche semi-conductrice (102) comporte des trous (140) la traversant et qui sont disposés chacun entre deux boîtes quantiques (104) adjacentes disposées en regard d'une même première grille de commande (114) et/ou entre deux boîtes quantiques (104) adjacentes disposées en regard d'une même deuxième grille de commande (122).

5. Dispositif électronique (100) selon la revendication 4, dans lequel chaque trou (140) est disposé en regard d'une première grille de commande (114) et d'une deuxième grille de commande (122) chacune configurée pour commander le potentiel électrostatique d'au moins une des boîtes quantiques (104).

6. Dispositif électronique (100) selon l'une quelconque des revendications précédentes, comportant en outre des premiers éléments de contact électrique (136) couplés aux premières grilles de commande (114) et des deuxièmes éléments de contact électrique (138) couplé aux deuxièmes grilles de commande (122), et dans lequel les premiers et deuxièmes éléments de contact électrique (136, 138) sont disposés au niveau d'une même face du dispositif électronique (100).

7. Dispositif électronique (100) selon l'une quelconque des revendications précédentes, dans lequel des premiers éléments de contact électrique (136) sont couplés à des extrémités de premières portions conductrices (118) des premières grilles de commande (114) et disposées à des distances différentes par rapport à un premier bord de la couche semi-conductrice (102), et/ou dans lequel des deuxièmes éléments de contact électrique (138) sont couplés à des extrémités de deuxièmes portions conductrices (128) des deuxièmes grilles de commande (122) et disposées à des distances différentes par rapport à un deuxième bord de la couche semi-conductrice (102).

8. Procédé de réalisation d'un dispositif électronique (100), comportant au moins les étapes suivantes :
- réalisation de plusieurs premières grilles de commande (114) disposées les unes à côté des autres du côté d'une première face (116) d'une couche semi-conductrice (102) comprenant une matrice de boîtes quantiques (104) et des régions de couplage (106) chacune disposée entre deux boîtes quantiques (104) adjacentes, recouvrant au moins une partie de la matrice de boîtes quantiques (104) et des régions de couplage (106), et configurées pour commander chacune le potentiel électrostatique d'au moins une des boîtes quantiques (104) ou d'au moins une des régions de couplage (106) ;
- réalisation de plusieurs deuxièmes grilles de commande (122), disposées les unes à côté des autres du côté d'une deuxième face (124), opposée à la première face (116), de la couche semi-conductrice (102), recouvrant au moins une partie de la matrice de boîtes quantiques (104) et des régions de couplage (106), et configurées pour commander chacune le potentiel électrostatique d'au moins une des boîtes quantiques (104) ou d'au moins une des régions de couplage (106) ;
dans lequel les premières grilles de commande (114) s'étendent selon leur plus grande dimension parallèlement à un premier axe et les deuxièmes grilles de commande (122) s'étendent selon leur plus grande dimension parallèlement à un deuxième axe, dans lequel des projections des premier et deuxième axes dans un même plan sont sécantes, dans lequel chacune des boîtes quantiques (104) est disposée en regard d'une des premières grilles de commande (114) et d'une des deuxièmes grilles de commande (122), et dans lequel chacune des régions de couplage (106) est disposée en regard d'une des premières grilles de commande (114) et d'une des deuxièmes grilles de commande (122).

9. Procédé de réalisation selon la revendication 8, comportant en outre, entre la réalisation des premières grilles de commande (114) et la réalisation des deuxièmes grilles de commande (122), une réalisation de trous (140) traversant la couche semi-conductrice (102) et chacun disposé entre deux boîtes quantiques (104) adjacentes disposées en regard d'une même première grille de commande (114) et/ou entre deux boîtes quantiques (104) adjacentes disposées en regard d'une même deuxième grille de commande (122).

10. Procédé de réalisation selon l'une des revendications 8 ou 9, dans lequel la couche semi-conductrice (102) correspond à au moins une partie d'une couche superficielle (154) d'un substrat de type semi-conducteur sur isolant.

11. Procédé de réalisation selon la revendication 10, dans lequel la réalisation des premières grilles de commande (114) comporte au moins la mise en œuvre des étapes suivantes :
- réalisation d'au moins une première couche diélectrique (108) et d'une première couche conductrice (156) sur la couche superficielle (154) ;
- gravure de la première couche conductrice (156) telle que les portions restantes (118) de la première couche conductrice (156) et la première couche diélectrique (108) forment les premières grilles de commande (114).

12. Procédé de réalisation selon l'une des revendications 10 ou 11, comportant en outre, entre la réalisation des premières grilles de commande (114) et la réalisation des deuxièmes grilles de commande (122), la mise en œuvre des étapes suivantes :
- réalisation d'une première couche d'encapsulation (110) recouvrant au moins les premières grilles de commande (114) ;
- solidarisation d'une couche de maintien mécanique (112) sur la première couche d'encapsulation (110) ;
- retrait d'une couche support (150) et d'une couche diélectrique enterrée (152) du substrat, révélant une deuxième face de la couche superficielle (154) correspondant à la deuxième face (124) de la couche semi-conductrice (102).

13. Procédé de réalisation selon la revendication 12 comportant en outre, entre le retrait de la couche support (150) et de la couche diélectrique enterrée (152) et la réalisation des deuxièmes grilles de commande (122), une étape de gravure d'une partie de la couche superficielle (154) telle qu'une portion restante de la couche superficielle (154) forme la couche semi-conductrice (102), ou une oxydation d'une partie de la couche superficielle (154) telle qu'une portion non oxydée de la couche superficielle (154) forme la couche semi-conductrice (102).

14. Procédé de réalisation selon l'une des revendications 12 ou 13, dans lequel la réalisation des deuxièmes grilles de commande (122) comporte au moins la mise en œuvre des étapes suivantes :
- réalisation d'au moins une deuxième couche diélectrique (126) et d'une deuxième couche conductrice (160) sur la deuxième face de la couche superficielle (154) ;
- gravure de la deuxième couche conductrice (160) et de la deuxième couche diélectrique (126) telle que les portions restantes (128) de la deuxième couche conductrice (160) et de la deuxième couche diélectrique (126) forment les deuxièmes grilles de commande (122).

15. Procédé de réalisation selon l'une quelconque des revendications 12 à 14, comportant en outre la réalisation de premiers éléments de contact électrique (136) couplés aux premières grilles de commande (114) à travers la première couche d'encapsulation (110), et la réalisation de deuxièmes éléments de contact électrique (138) couplés aux deuxièmes grilles de commande (122) à travers une deuxième couche d'encapsulation (134) préalablement déposée et recouvrant les deuxièmes grilles de commande (122).
